# EUROPEAN PATENT SPECIFICATION

(11) **EP 0 570 224 B1**
(45) Date of publication and mention of the grant of the patent: **31.12.2008**
(21) Application number: 93303709.5
(22) Date of filing: 13.05.1993
(51) Int. Cl.: H01L 21/76, H01L 21/20, H01L 27/12, H01L 27/14, G02F 1/1362, G06E 3/00

(54) **Semiconductor device**
Halbleitervorrichtung
Dispositif à semi-conducteur

(30) Priority: 14.05.1992 JP 12202492
(43) Date of publication of application: 18.11.1993
(73) Proprietor: Seiko Instruments Inc., Tokyo 136 (JP)
(72) Inventor: Iwaki, Tadao, c/o Seiko Instruments Inc., Koto-ku, Tokyo (JP); Yamazaki, Tsuneo, c/o Seiko Instruments Inc., Koto-ku, Tokyo (JP); Matsushita, Katsuki, c/o Seiko Instruments Inc., Koto-ku, Tokyo (JP); Senbonmatsu, Shigeru, c/o Seiko Instruments Inc., Koto-ku, Tokyo (JP); Takano, Ryuichi, c/o Seiko Instruments Inc., Koto-ku, Tokyo (JP)
(74) Representative: Sturt, Clifford Mark

(56) References cited:
- EP-A- 0 182 032
- EP-A- 0 262 024
- US-A- 4 875 086
- US-A- 5 091 330
- SEMICONDUCTOR SCIENCE AND TECHNOLOGY, vol. 7, no. 1A, 1 January 1992, pages A243-A248, XP000243988 WADA S ET AL: "SILICON DEVICE THINNING USING PREFERENTIAL POLISHING: PROGRESS IN FLATNESS AND ELECTRICAL PROPERTIES"
- INTERNATIONAL ELECTRON DEVICES MEETING, 1 - 4 December 1985, WASHINGTON, DC, USA, pages 688-691, XP002037723 T. HAMAGUCHI ET AL.: "Novel LSI/SOI wafer fabrication using device layer transfer technique"

## Description

The present invention relates to semiconductor elements, devices incorporating such elements and methods of manufacturing such semiconductor elements.

In conventional semiconductor thin film elements using glass substrate and silicon, thin film transistors have been formed on the surface of an amorphous silicon thin film or polycrystalline silicon thin film deposited on a glass substrate. The amorphous silicon thin film and polycrystalline silicon thin film are suitable for manufacturing semiconductor thin film elements with a relatively large area (for instance, for active matrix liquid crystal devices) because they can be deposited easily on a glass substrate using chemical vapour deposition.

Recently, thin film switching elements have been formed, each of which has a two layered structure being of an insulating substrate and a semiconductor crystal formed thereon. Various types of switching elements having such a two-layered structure have been known and are the so-called silicon-on-insulator (SOI) substrates. The SOI substrate can be produced by depositing a polycrystalline silicon thin film on a substrate surface of, for example, insulating material using chemical vapour deposition and then by heating it using a laser beam to recrystallise the polycrystalline to a single crystal structure. Another type of SOI substrate can be produced by oxidising thermally the surface of a single crystal silicon wafer, then by subjecting it to a thermo-press bonding with a silica substrate or a single crystal silicon substrate, and finally by polishing or etching to process the single crystal silicon wafer to a predetermined thickness.

However, in conventional semiconductor thin film elements using amorphous or polycrystalline silicon thin film sub-micron transistor elements cannot be formed by applying fine semiconductor manufacturing techniques. For example, as the amorphous silicon thin film is formed at a temperature of about 800°C, high temperature processing, necessary to the miniaturising technology, cannot be carried out. Furthermore, as polycrystalline silicon thin film, which is used for a semiconductor thin film element, has a crystalline grain size of several µm it is limited naturally to miniaturise a thin film element. As the polycrystalline silicon thin film is formed at a temperature of about 600°C, it is impossible to employ fully the miniaturising technique where processing at a high temperature of more than 1000°C is included.

Generally, the SOI substrate, which is formed by recrystallising a polycrystalline film to convert to a single crystal structure, does not have a uniform crystalline structure and has large lattice defect density. In the SOI substrate, which is formed by thermo-press bonding a single crystal silicon and a silica substrate, there is a disadvantage in that as the difference in the thermal expansion coefficient between the single crystal silicon and the silica substrate is large, the silicon thin film may peel or crack during a high temperature process at over 1000°C.

Moreover there has been no transparent insulating substrate which is low in price, has a coefficient of thermal expansion similar to that of a single crystal silicon, and has a resistance to change during high temperature processing over 1000°C. For these reasons, it has been difficult to apply device miniaturising technology used with a single crystal silicon wafer, to an SOI substrate manufactured by conventional means. There is also a disadvantage in that it has been difficult to form a three-dimensionally integrated semiconductor circuit element because semiconductor circuit elements cannot be formed over both the internal surfaces at the thermo-press bonded portions.

Document "International Electron Devices Meeting", 1-4 December 1985, Washington DC, USA, pages 688-691 describes LSI/SOI wafer fabrication using a device layer transfer technique.

US patent 5,091,330 describes a method of fabricating a dielectric isolated area.

Document "Semiconductor Science and Technology" Vol. 7, No.lA, January 1992 pages A243-A248 describes silicon device thinning using preferential polishing.

In order to overcome the above problems, the semiconductor thin film element according to the present invention is made by forming sequentially a thermally oxidised silicon film, a single crystal silicon thin film sandwiched between silicon oxide or nitride firms, an element smoothing layer, a resin adhesive layer, and a glass substrate.

A SOI substrate is formed by subjecting them to a thermo-press bonding after the surfaces of two single crystal silicon substrates are thermally oxidised; and then processing one of the silicon substrates to a predetermined thickness through polishing or etching. In the SOI substrate, as there is no substantial difference between the thermal expansion coefficients of the materials bonded to each other, electrical circuits of sub-micron order can be formed easily on the surface of the single crystal silicon thin film by performing device miniaturising processes at over 1400°C. In the SOI substrate formed thus, after a surface whereon electrical circuits are formed is adhered with the above structure, the single crystal silicon substrate, where no electrical circuits are formed, is removed through polishing and etching. According to the present invention, it is possible to solve the above problems because three dimensional semiconductor circuit elements in both the inner surfaces can be formed which are connected electrically to each other in the adhesive layer.

According to the present invention there is provided a semiconductor element comprising a laminated structure of:
a single crystal silicon thin film layer, at least one semiconductor circuit element being formed on or in a surface of the single crystal silicon thin film layer;
a silicon oxide layer formed on the other surface of the single crystal silicon thin film layer;
an insulating layer formed on the opposite side of the single crystal silicon thin film layer to the silicon dioxide layer, for protecting the at least one semiconductor circuit element;
an element smoothing layer on the opposite side of the insulating layer to the silicon oxide layer;
a resin adhesive layer on the opposite side of the element smoothing layer to the insulating layer; and
a supporting substrate on the opposite side of the resin adhesive layer to the element smoothing layer,
wherein the surface of the element smoothing layer further from the semiconductor circuit element is smoother than the surface of the element smoothing layer closer to the semiconductor circuit element.

The supporting substrate may be a single crystal silicon substrate, or may be a glass substrate.

The resin adhesive layer may be of an imide type resin or of an epoxy type resin, and preferably includes fluorine. The resin adhesive layer may include fine particles, preferably of controlled diameter in the range 5 to 15µm. In some applications, the resin adhesive layer may, with advantage, have a shore hardness of more than 80.

The element smoothing layer may comprise a silicon oxide film, or may be of an an imide type resin or of an epoxy type resin.

The difference in linear coefficient of expansion between the supporting substrate and the single crystal silicon thin film layer is preferably less than 1.5 x 10⁻⁶/°C.

Other aspects of the present invention will be apparent from the appended claims; and how the present invention can be carried into effect is hereinafter particularly described with reference to the accompanying drawings in which:-
Figure 1 is a diagrammatic cross sectional view of a semiconductor thin film element according to the present invention;
Figure 2 is a similar view of another embodiment of an element according to the present invention;
Figure 3 is a similar view of yet another embodiment of an element according to the present invention;
Figure 4 is a similar view of another embodiment of an element according to the present invention;
Figure 5 is a diagram showing the structure of a transistor formed in an element according to the present invention;
Figure 6 is a diagram showing the structure of an embodiment of an optical detector formed in an element according to the present invention;
Figure 7 is an elevation of a wafer from which an element according to the present invention may be formed;
Figure 8 is a diagrammatic cross-sectional view of a substrate for a semiconductor element according to the present invention;
Figure 9 is a layout diagram of an integrated circuit chip formed on the substrate of a semiconductor element according to the present invention;
Figure 10 is an enlarged diagram of a portion of an integrated circuit chip in Figure 9 used as a liquid crystal light valve;
Figure 11 is an enlarged diagram of a portion of an integrated circuit chip in Figure 9 used as an optical detector array;
Figures 12(A) to 12(D) are diagrams illustrating the first steps in a semiconductor element manufacturing process according to the present invention;
Figures 13(A) to 13(D) are diagrams illustrating the further steps in a semiconductor element manufacturing process according to the present invention;
Figure 14(A) to 14(C) are diagrams illustrating further steps in a semiconductor element manufacturing process according to the present invention;

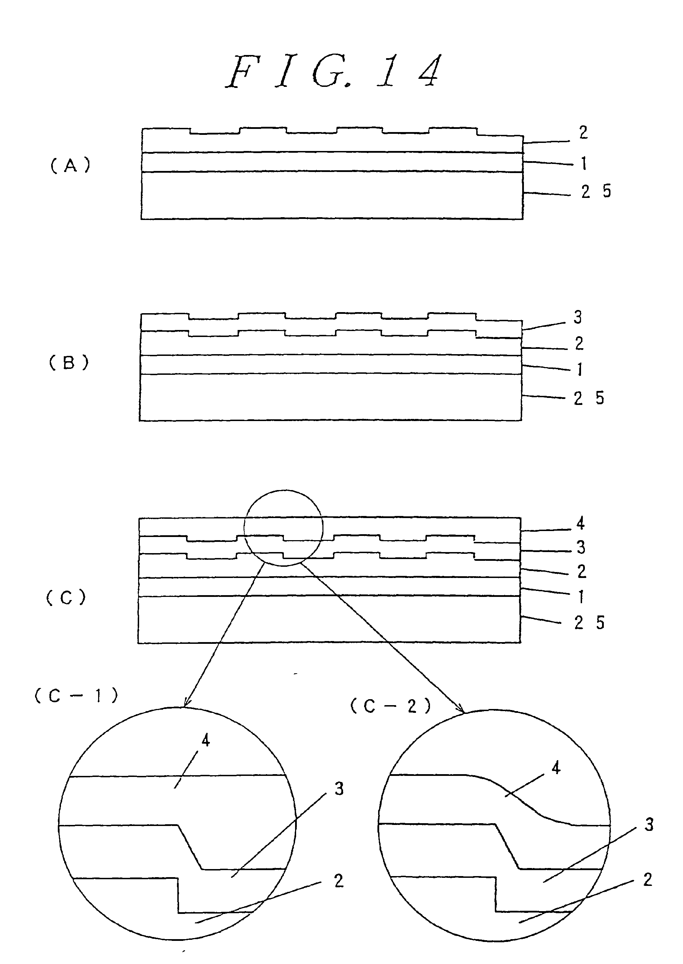

Figure 14(C-1) and 14(C-2) are enlarged views of part of Figure 14(C);

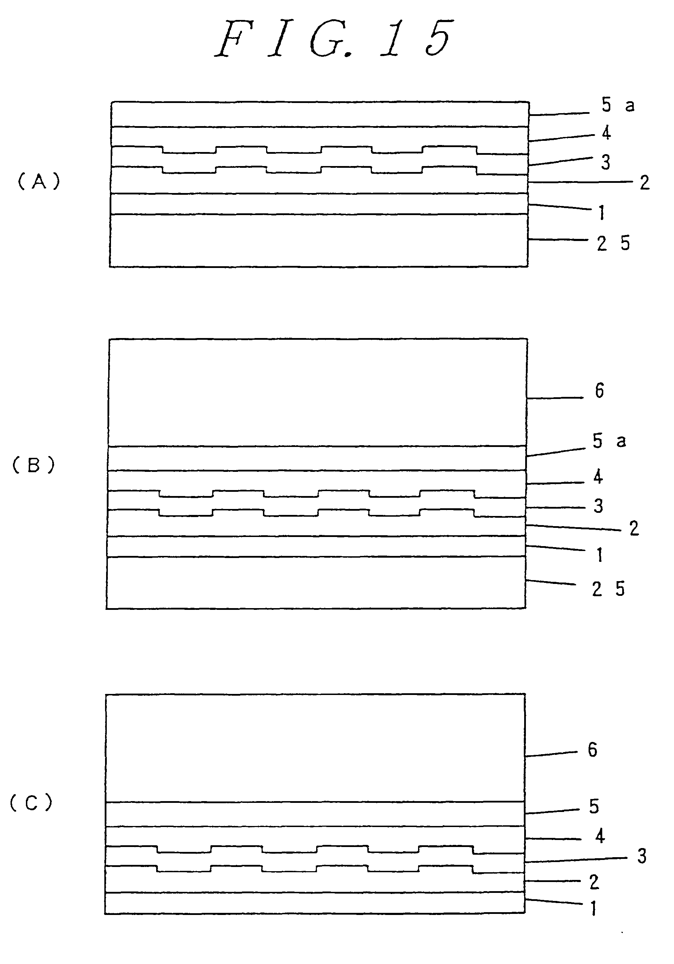

Figures 15(A) to 15(C) are diagrams illustrating further steps in a semiconductor element manufacturing process according to the present invention;

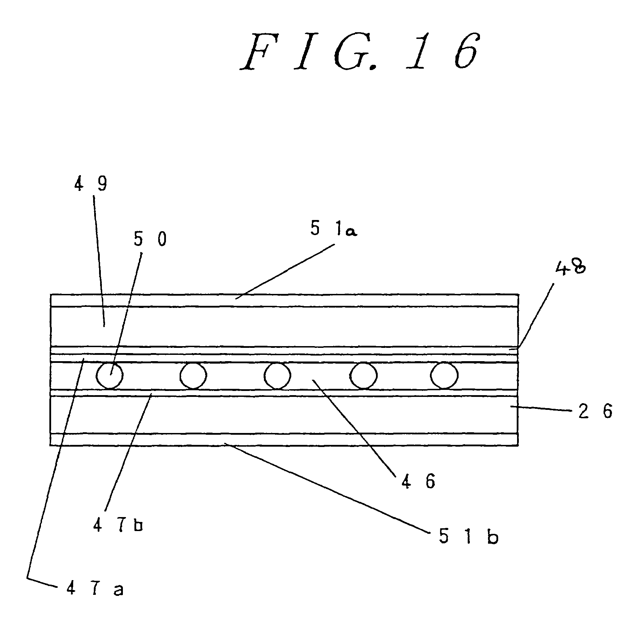

Figure 16 is a diagrammatic cross sectional view showing another embodiment of a semiconductor element according to the present invention;

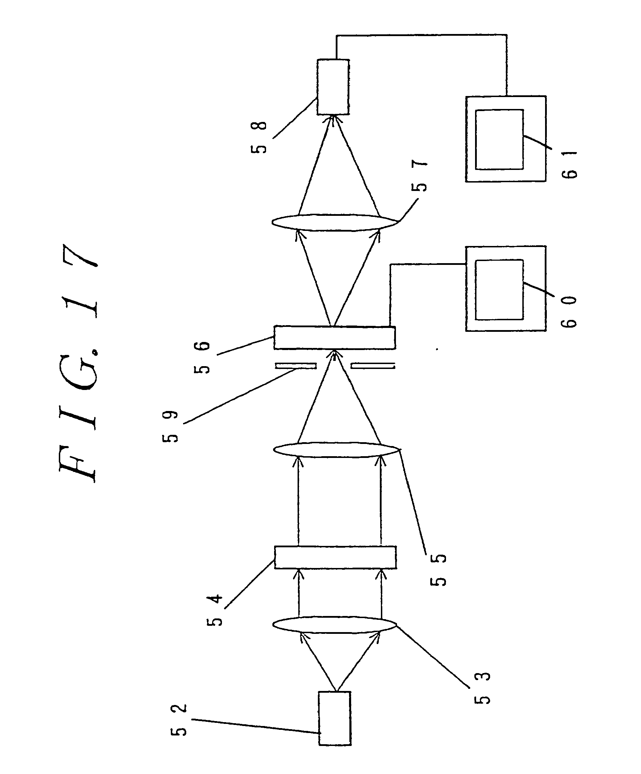

Figure 17 is a diagrammatic view of an optical detector incorporating a semiconductor element according to the present invention;

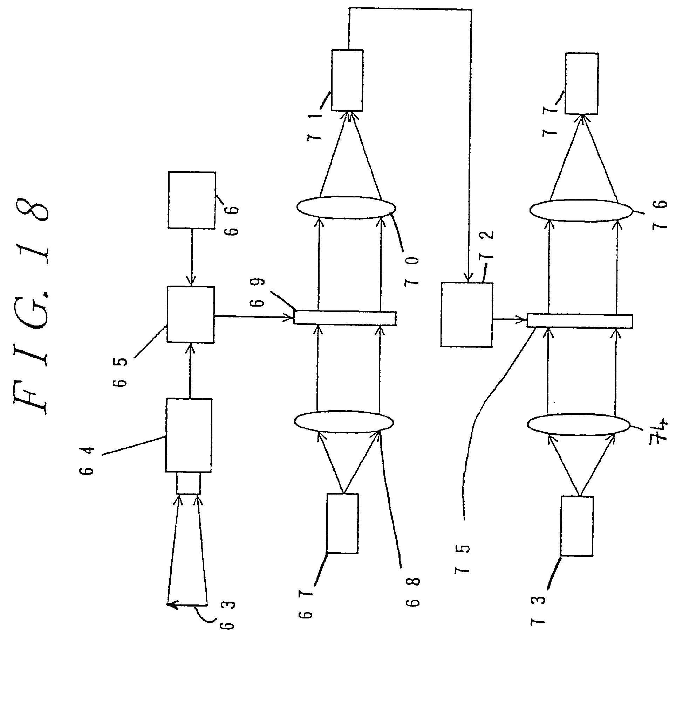

Figure 18 is a diagrammatic view of an optical correlation device incorporating a liquid crystal light valve using a semiconductor element according to the present invention; and

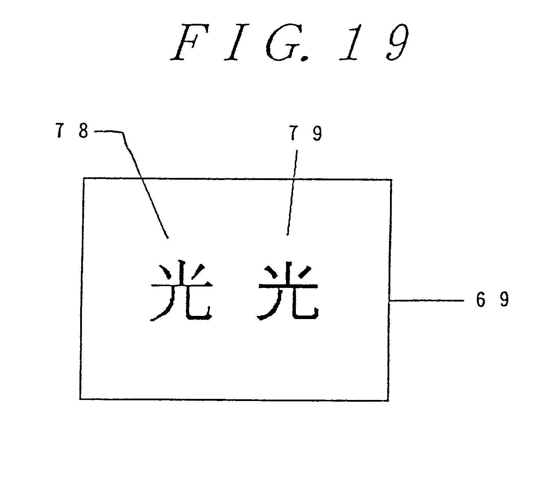

Figure 19 is a diagram showing an embodiment of input and reference images in a liquid crystal element of an optical correlation device.

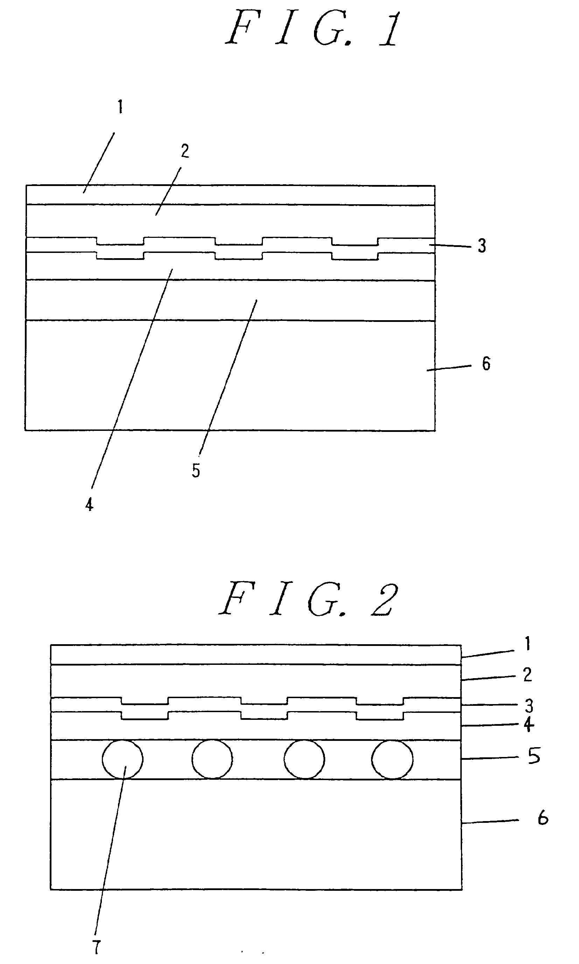

A semiconductor thin film element according to the present invention includes a thermally oxidised silicon oxide film 1 (Figure 1), a single crystal silicon thin film 2, a thermally oxidised silicon oxide film 3, an element smoothing layer 4, a resin adhesive layer 5 and a supporting substrate 6. A semiconductor circuit element is formed on the single crystal silicon thin film 2 by a miniaturising semiconductor structure manufacturing technique. A silicon nitride film may be used instead of the silicon oxide film 3.

The single crystal silicon used for the single crystal silicon thin film 2 is made of a SOI substrate. The SOI substrate is formed by subjecting a single crystal silicon wafer to a thermally grown oxidising process, then by bonding the wafer thermally and compressively to a single crystal silicon substrate, and by processing the single crystal silicon wafer to a predetermined thickness by polishing or etching. As the quality of the single crystal silicon wafer is substantially maintained, the SOI substrate has an excellent quality as regards uniformity of crystal orientation and lattice defect density.

Therefore the crystal orientation can be selected arbitrarily and a semiconductor circuit element can be formed accurately and in high density using a conventional method of miniaturising semiconductor manufacturing. Whilst the thickness of the single crystal silicon thin film 2 can be taken down to any amount more than about 0.3 µm, the thickness should be over 0.6 µm or preferably over 0.8 µm, in order to operate normally a thin film transistor build using the conventional miniaturising semiconductor manufacturing method.

In a similar manner to the single crystal silicon thin film 2, the thermally oxidised silicon oxide film 1 is also made from a SOI substrate. A semiconductor circuit element is formed on the face of the single crystal silicon film 2 remote from film 1. The single crystal silicon thin film 2 is adhered to the supporting substrate 6 by the resin adhesive layer 5 through the silicon oxide or nitride film 3 and the element smoothing layer 4. When material is removed from the single crystal silicon substrate by polishing or etching, the thermally oxidised silicon film 1 blocks the polishing or etching while protecting electrically the semiconductor circuit element formed in the single crystal silicon thin film from the external environment. The thickness of the thermally grown silicon thin film is determined when the SOI substrate is formed. If, for example, an anistropic etching is used with the usual KOH solution, the thickness needs to be at least 0.1 µm to ensure the parallelism and flatness of the single crystal silicon substrate, as well as in consideration of the etch rate difference between the silicon and the thermally oxidised silicon.

The silicon oxide or nitride film 3 moderates the internal stress occurring within the single crystal silicon thin film 2 while preventing the single crystal silicon thin film 2 from being peeled due to polishing or etching. The silicon oxide or nitride film 3 also stabilises the characteristics of the semiconductor circuit element, prevents a breakage of metal electrodes due to internal stress, and improves the mechanical strength of the single crystal silicon thin film 2. In order to obtain the full benefit of such functions, the thickness of the silicon oxide or nitride film 3 is preferably substantially 2 µm or less.

When the single crystal silicon thin film 2 with the semiconductor circuit element formed therein is adhered to the supporting substrate 6 by the resin adhesive layer 5 through the silicon oxide nitride film 3, and the element smoothing layer 4, the element smoothing layer 4 reduces the internal stress in the resin adhesive layer 5 caused by curing or shrinkage of the adhesive agent, thus preventing the single crystal silicon thin film 2 from being peeled through polishing or etching.

It is desirable that the element smoothing layer 4 completely flattens the surface of the silicon oxide or nitride film 3. A sufficient effect is achieved even if the edges of the surface are rounded. The element smoothing layer 4 improves the mechanical strength of the single crystal silicon thin film 2.

It is desirable to use a silicon oxide or an imide type resin or epoxy type resin as the material of the element smoothing layer 4. The silicon oxide is made by dissolving an organic type silicon compound such as silicon alkoxide with a solvent, by coating the solution on the silicon oxide or nitride film 3, and then by heating it at 150° to 300°C. The imide type resin or epoxy type resin is applied by coating with an imide type monomer or epoxy type monomer in a solvent, and then heating to cure the monomer. The thickness of the element smoothing layer 4 should be less than 2 µm, because a thickness of more than 2 µm causes internal stress in the element smoothing layer 4, thus resulting in peeling of the single crystal silicon thin film 2.

Many different kinds of material may be used for the supporting substrate 6. Heat which occurs during the semiconductor thin film element manufacturing steps according to the present invention causes internal stress in the single crystal silicon thin film 2 or the resin adhesive layer 5. The stress may vary the characteristics of the semiconductor circuit element with time and peel the single crystal silicon thin film 2 from the supporting substrate 6.

It is desirable to use a supporting substrate material which has a coefficient of linear expansion differing by less than 1.5 x 10⁻⁶/°C from that of the single crystal silicon. For example, in order to manufacture transparent type optical elements using the semiconductor thin film elements according to the present invention, Pyrex glass may be used for a glass substrate. Silicon single crystal wafer may be used to manufacture reflex type optical elements and three-dimensional semiconductor circuit elements.

In the polishing, etching and various cleaning steps for manufacturing the semiconductor thin film element according to the present invention, the resin adhesive layer 5 must withstand corrosion due to etching fluid and cleaning fluid, as well as having strong adhesive power. Fluorine epoxy series resin material is suitable for the resin adhesive layer 5. This material is an epoxy series resin including fluorine in various ratios as adjective radical and has good chemical resistance. The adhesive layer can be controlled as to refractive index and viscosity before curing by adjusting the amount of fluorine.

The resin adhesive layer normally has a thickness between 2 and 50 µm. The thickness can be controlled by adjusting the load applied against the single crystal silicon and the supporting substrate 6 during adhesion, and the viscosity of the resin adhesive layer 5 prior to curing. In most semiconductor thin film elements according to the present invention, the thickness of the resin adhesive layer 5 is controlled to 10 to 20 µm.

However, it is difficult to minimise the variations in thickness of the resin adhesive layer 5 by using conventional adhesion methods. Accordingly, in order to minimise variations in thickness of the resin adhesive layer 5, fine particles 7 (Figure 2) are mixed in the resin adhesive layer 5 to control the thickness thereof. Fibre balls or beads made of silicon dioxide or high molecular resin may be used as the fine particles 7. Such fine particles are commercially available with various diameters thereof controlled to ± 1 to 15%. The resin adhesive layer 5 can be controlled to a predetermined thickness ± 1 % to ± 5 % by mixing fine particles of controlled diameters in the layer, preferably with a diameter of 5 to 15 µm.

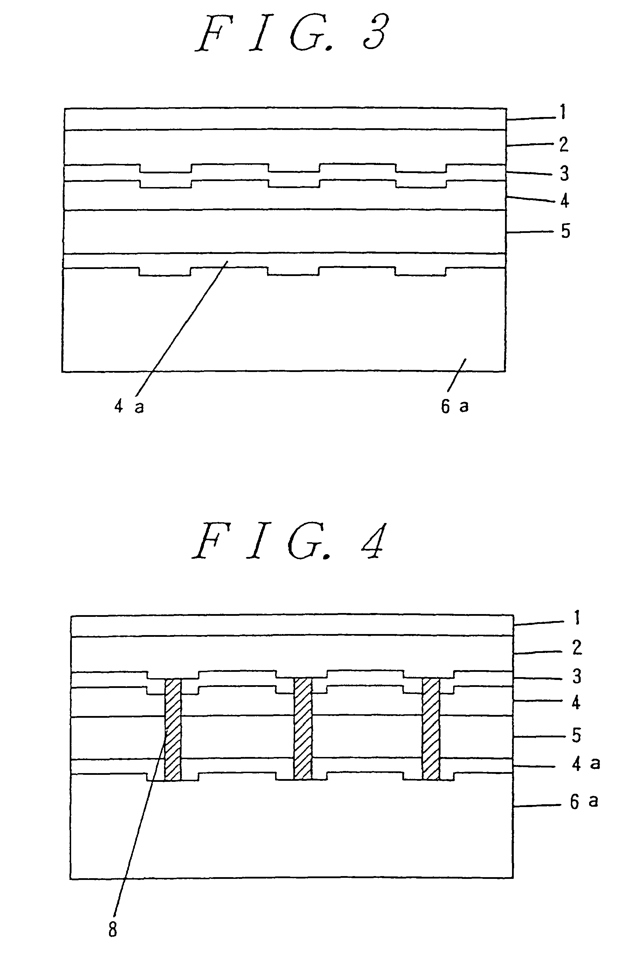

In another embodiment of the present invention the supporting substrate may be a single crystal silicon wafer 6a (Figure 3) on which semiconductor circuit elements are formed. A second element smoothing layer 4a is formed between the resin adhesive layer 5 and the single silicon wafer 6a, so as to reduce the internal stress in the resin adhesive layer 5 caused by curing and shrinkage of the resin adhesive agent, thus preventing the single crystal silicon thin film 2 from peeling during polishing and etching. The second element smoothing layer 4a has a thickness of less than 2 µm.

The two-layered semiconductor circuit element formed thus can couple optically semiconductor circuit elements formed on the single crystal silicon thin film 2 to semiconductor circuit elements formed in the single crystal silicon wafer 6a, thus packing substantially a large-scale integrated circuit in a small area without delaying clocks.

In another embodiment of the present invention, two layered semiconductor circuit elements are electrically coupled to each other by the provision of through holes 8 (Figure 4) filled with electrically conductive material such as metal. The through holes 8 may penetrate the thermally oxidised silicon film 1, the single crystal silicon thin film 2, the silicon oxide or nitride film 3, the element smoothing layer 4, the resin adhesive layer 5, and the second element smoothing layer 4a. Metal in the through holes 8 connects electrically the semiconductor circuit elements formed in the single crystal silicon thin film 2 to the semiconductor circuit elements formed in the single crystal silicon wafer 6a. The through holes 8 can be formed easily using a miniaturising semiconductor manufacturing technique and a thin film forming method. Holes of a desired depth, for example, are formed at a desired position through dry etching in an oxygen-containing atmosphere and then metal such as aluminium or chromium is sputtered at the desired position thereof.

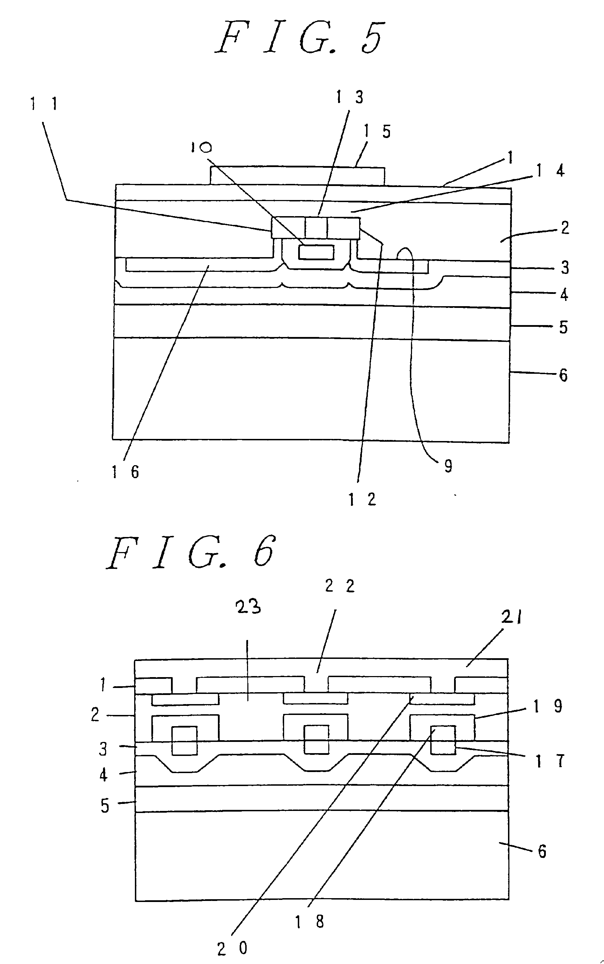

In a transistor structure formed in a single crystal silicon thin film of another embodiment of semiconductor thin film element according to the present invention, the transistor has a drain region 12 (Figure 5) and a source region 11 which are formed separately in the single crystal silicon thin film 2. The drain region 12 is connected to a signal line 9 while the source region 11 is connected to a source electrode 16. A channel region 13 is formed between the drain region 12 and the source region 11. A main gate electrode 10 is formed on the back side of the channel region 13 by way of a gate oxide film 14. The main gate electrode 10 controls the conductance of the channel region 13 and performs on/off operation of the transistor.

A light shielding film 15 is arranged on the other side of the channel region 13 to the gate electrode 10 on the surface of the thermally oxidised silicon film 1. The light shielding film 15 is formed as a thin film of metal, such as chromium, aluminium, or molybdenum, and acts as a sub-gate electrode for controlling the back channel. The gate and sub-gate electrodes 10 and 15 arranged on either side of the channel region 13 are made of a light shielding material and can shield light from entering the channel region 13.

According to the present invention, the channel region 13 is formed in a single crystal silicon thin film. A conventional LSI processing technique is directly applicable to fine the channel length thereof to an order of submicron.

The transistor structure (Figure 5) has an uneven surface even after the formation of film 3. If the semiconductor circuit element with the uneven surface were to be adhered directly to the supporting substrate 6 by the resin adhesive layer 5, internal stress may occur in the resin adhesive layer 5, thus causing peel off of the film 2 carrying the semiconductor circuit element. For this reason, the uneven surface is smoothed or flattened using the element smoothing layer 4 of silicon oxide or imide series or epoxy type resin.

The resin adhesive layer 5 may be used with fine particles mixed therein to minimise variations in thickness.

In yet another embodiment according to the present invention, an optical detector is built in a semiconductor thin film element which includes a glass substrate 6 (Figure 6) emitter electrodes 17; first N-type regions 18, P-type regions 19, second N-type regions 20, a transparent electrode 21, an 1-type region 23 and through holes 22. The transparent glass substrate 6a is of Pyrex glass which has a coefficient of linear expansion of about 3 x 10⁻⁶/°C at normal temperature. The value is close to the coefficient of linear expansion of the silicon, or about 2.4 x 10⁻⁶/°C at normal temperature. Silica glass has a coefficient of linear expansion of about 0.4 x 10⁻⁶/°C at normal temperature and soda glass has a coefficient of about 8 x 10⁻⁶/°C at normal temperature. These, therefore, have a larger difference in coefficient of linear expansion compared to that of silicon. The thermal stress at the junction which occurs in a semiconductor thin film may peel off the adhered portion. In order to prevent the element peeling, it has been found preferable to use a glass material having a coefficient of linear expansion with no more difference than 1.5 x 10⁻⁶/°C from that of the single crystal silicon.

The optical detector shown is a three electrode element with an NPN junction, which requires no base electrode because light works as a base current, so that the optical detector is switched in response to light illumination. The first N-type regions 18, P-type regions 19, and the second N-type regions 20 are formed separately in the single crystal silicon thin film 2. The intrinsic 1-type region 23 is formed between the P-type regions 19 and the second N-type regions 20. The second N-type regions 20 are connected electrically to the transparent electrode 21 (which may be an ITO electrode) by way of the through holes 22. The transparent electrode 21 corresponds to the collector electrode of a transistor. Each first N-type region 18 is connected to an emitter electrode 17.

The transparent electrode 21 thus connected is used as a positive electrode. When the optical detector is illuminated with light while a voltage is applied between the emitter electrode 17 and the transparent electrode 21, light current is obtained corresponding to the amount of illuminated light. The structure inducing the emitter regions 17, the P-type regions 19 and the like can be formed easily on the single crystal silicon thin film underlying the SOI substrate, using conventional miniaturised semiconductor manufacturing techniques. Hence, an optical detector can be made by the semiconductor thin film element manufacturing method according to the present invention.

In an alternative embodiment of the present invention, a two terminal optical detector with PN junction can be used in place of the three terminal photo detector NPN junction.

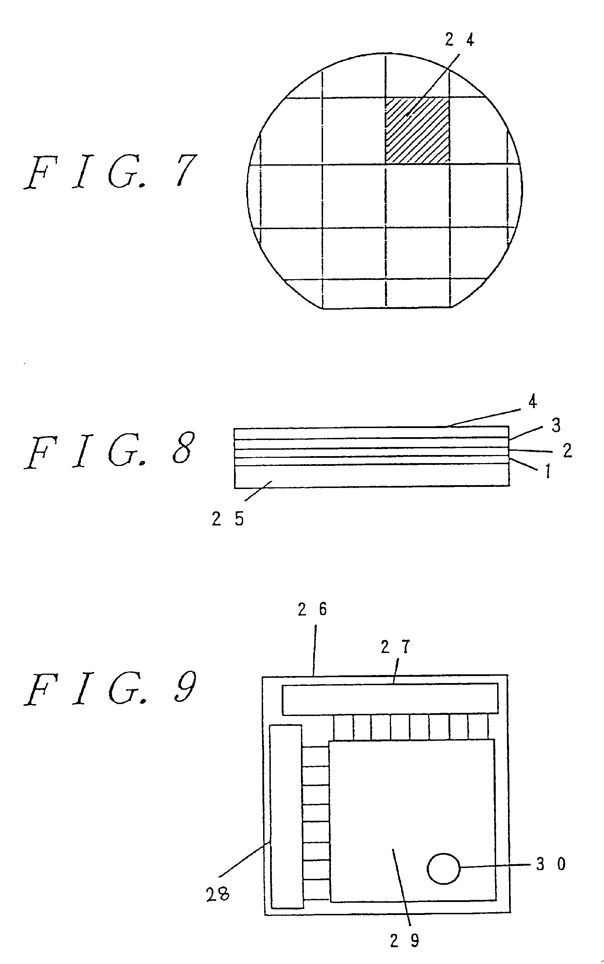

In the manufacture of a SOI substrate, single crystal silicon wafers are prepared. It is desirable to use a high quality silicon wafer for LSI manufacture as the single crystal silicon wafer. The crystalline orientation is <100>. The uniformity ranges 0.0 ± 1.0. The single crystal lattice defect density is less than 500/cm². The surfaces of a single crystal silicon wafer are precisely polished and a thermally oxidised silicon is formed on one or both surfaces thereof. Thereafter, another single crystal silicon wafer 25 (Figure 8) is piled on the thermally oxidised silicon on at least one surface of the one silicon wafer. Then both the silicon wafers are heated and thermo-press bonded to each other. The thermo-press bonding process fixes securely both the wafers to each other.

Next, the other surface of the one single crystal silicon wafer is polished and in order to form the single crystal silicon thin film 2, may be thinned either by etching, or by polishing and etching instead of polishing alone. As a result, the structure comprises the single crystal silicon wafer 25, the thermally oxidised silicon film 1, and the single crystal silicon thin film 2.

As the single crystal silicon thin film 2 thus obtained maintains substantially the quality of the single crystal silicon wafer, it is a very good film as regards uniformity of crystalline orientation and lattice defect density. In contrast a conventional single crystal silicon thin film formed of deposited amorphous or recrystallised polycrystalline silicon thin film is not stable for LSI manufacture because of the existence of many lattice defects and no uniform crystal orientation.

A semiconductor circuit element is formed on the single crystal silicon thin film 2 of the SOI substrate, as described in connection with any of the foregoing embodiments and as shown in Figure 14(A). A silicon oxide or nitride film 3 (Figure 14(B)) is formed on the thin film 2 using either physical vapour deposition including sputtering and vacuum vapour deposition or chemical vapour deposition. The film 3 protects the semiconductor element while it moderates internal stress in the single crystal silicon thin film 2. The thickness of the silicon oxide or nitride film 3 depends on the thickness of the single crystal silicon thin film 2 or the semiconductor circuit element structure. The thickness may be less than about 2 µm, and preferably 1 to 2 µm.

Next, an element smoothing layer 4 (Figure 14(C)) is formed on the silicon oxide or nitride film 3 in order to smooth the uneven surface of the semiconductor circuit element formed in the single crystal silicon thin film 2. In an example of forming the smoothing layer 4, an organic silicon compound, such as silicon alkoxide is dispersed and dissolved in an organic solvent. The resultant solution is spin-coated on the SOI substrate on which the silicon oxide or nitride film 3 is formed. The coating amount depends on the rotational speed of a spin coater, the viscosity of the coating material, filling amount, and initial spreading distribution.

The SOI substrate is heated in an oxygen-containing atmosphere at 50° to 180°C to react to the organic silicon compound dispersed and dissolved in the organic solvent which is coated thereon. Thus, a smoothing layer of silicon oxide is formed on the silicon oxide or nitride film 3. The layer 4 (Figure 14(C-2) smooths the unevenness of the surface of the silicon oxide or nitride film 3 due to the semiconductor circuit element.

In another example of forming the element smoothing layer 4, an imide type resin in a solvent is spin-coated on the SOI substrate on which the silicon oxide or nitride film 3 has been formed. The resin is converted to a polyimide type polymer layer 4 by heating at 140° to 180°C. The polymide type polymer 4 (Figure 14(C-1)) thus formed completely smoothes the unevenness of the surface of the silicon oxide or nitride film 3 due to the semiconductor circuit element. It is preferable that the thickness of the element smoothing layer is less than about 2 µm.

The element smoothing layer 4 prevents the single crystal silicon thin film 2 from being peeled and reinforces it mechanically. The material for the element smoothing layer 4 must be a material which has sufficient corrosion resistance against etching fluid used in a subsequent removal step.

An adhesive agent 5a (Figure 15(A)) is coated on the element smoothing layer 4. An ultraviolet curable adhesive agent where fluorine epoxy type monomer is cured by ultraviolet rays may be used in order that the adhesive agent may have strong corrosion resistance against etching fluid used in the removal step. A supporting substrate 6 (Figure 15(B)) formed of glass and single crystal silicon wafer, is bonded, adhered and cured to the SOI substrate using the adhesive agent 5a. The adhesive agent 5a, when cured becomes a resin adhesive layer 5 (Figure 15(C)). By using an ultraviolet curable adhesive agent as the adhesive agent, a heating process for curing is avoided. If an adhesive agent, such as a general epoxy type adhesive agent or low melting point glass which requires heating for curing is used, the supporting substrate or SOI substrate may bend after curing because of any difference in coefficient of thermal expansion between the supporting substrate 6 and the single crystal silicon wafer 25. As a result, good semiconductor thin film elements cannot be manufactured. However, such a problem does not occur when a single crystal silicon wafer is used as the supporting substrate 6.

When an ultraviolet curing adhesive agent is used as the adhesive agent 5a, the substrate is heated to about 50°C through ultraviolet illumination. Hence when a glass substrate is used as the support substrate 6, it is desirable to use Pyrex glass because the difference between the coefficients of thermal expansion of the Pyrex glass supporting substrate and of the single crystal silicon wafer 25 is small. Such difference should be less than 1.5 x 10⁻⁶/°C.

After the supporting substrate 6 is adhered to the SOI substrate by the resin adhesive layer 5, the single crystal silicon wafer 25 is polished with a diamond blade to a thickness of about 100 µm. Then the single crystal silicon wafer 25 is controlled to a thickness of about 70 µm by performing a rough and finish polishing using an abrasive, such as cerium oxide and alumina. The SOI substrate is immersed in 35% KOH solution at 80°C and the single crystal silicon wafer 25 is completely removed by anisotropic etching. Etching can be stopped completely by the thermally oxidised silicon layer 1 because the etching rate is several hundreds times different between the single crystal silicon wafer 25 and the thermally oxidised silicon film 1. Thus, the thin film semiconductor element (Fig. 15(C)) according to the present invention can be made.

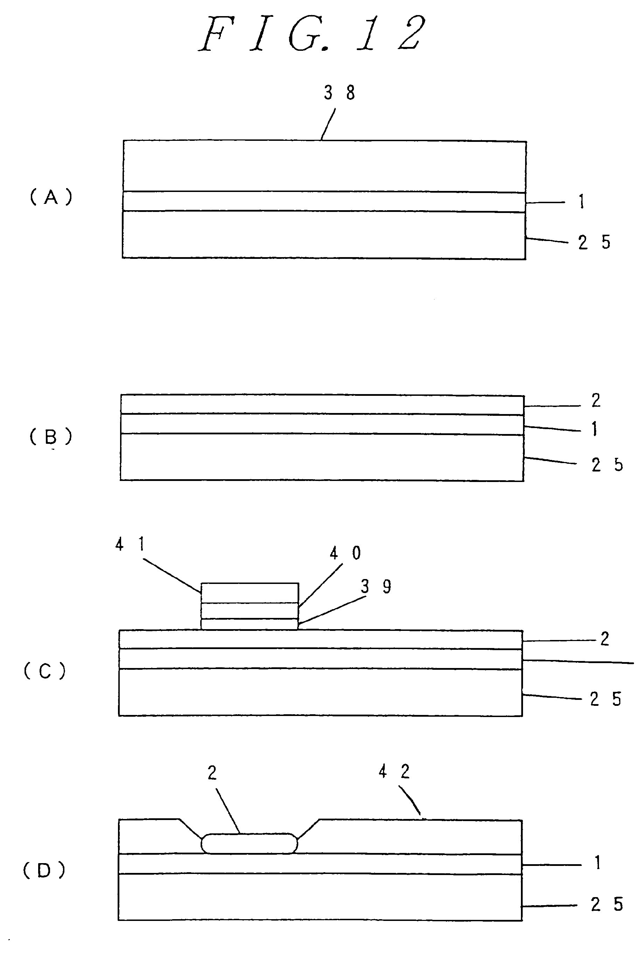

In order to manufacture a thin film transistor as a basic element in a thin film semiconductor element according to the present invention on a single crystal silicon thin film, a second single crystal silicon wafer 38 (Fig. 12(A)) is heated and thermo-press bonded to a single silicon wafer 25 through a thermally oxidised silicon film 1. The second single crystal silicon wafer 38 is thinned by polishing and etching to form a single crystal silicon thin film 2 in a SOI structure (Fig. 12 (B)). The single crystal silicon thin film 2 is thinned to a thickness of not less than 0.6 µm, because a thickness of less than 0.6 µm is not desirable as it largely degrades the operational characteristics of the thin film transistor.

A silicon oxide protective layer 39 (Fig. 12(C)), is formed over the entire surface of the silicon semiconductor thin film 2 by thermal oxidation. A silicon nitride protective film 40 is deposited on the silicon oxide protective film 39 by chemical vapour deposition. A photoresist 41 is coated on the protective film 40. The photoresist 41 is patterned by photolithography and then removed except in a thin film transistor forming region (hereinafter referred to an element region). The regions of the silicon oxide protective film 39 and of the silicon nitride protective film 40 which are not covered by the photoresist 41 are removed by etching.

After the photoresist is removed, a field oxide film 42 (Fig. 12 (D)) is formed by subjecting the single crystal silicon thin film 2 to a thermal oxidation process while the silicon oxide protective film 39 and the silicon nitride protective film 40 covering the element region are used as a mask. The single crystal silicon thin film 2 is left in a region surrounded by the field oxide film 42 to form an element region. Then the silicon oxide protective film 39 and the silicon nitride protective film 40 acting as a mask are removed.

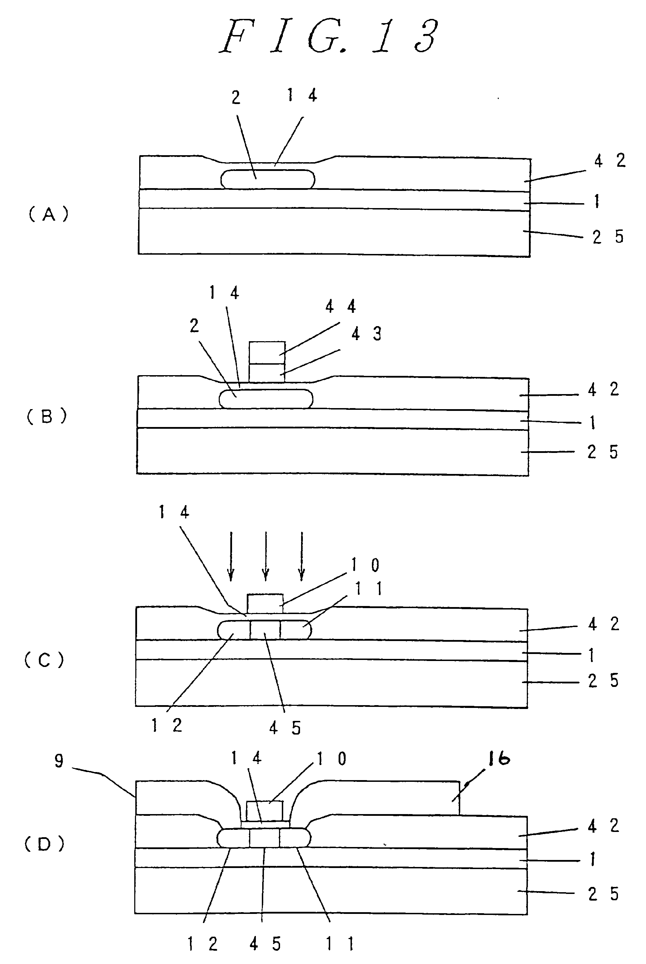

A gate oxide film 14 (Fig. 13(A)) is formed on the surface of the single crystal silicon thin film 2 by performing a thermal oxidation process again.

A polycrystalline silicon film 43 (Fig. 13 (B)) is deposited on the field oxide film 42 and gate oxide film 14 by chemical vapour deposition. The polycrystalline silicon film is selectively removed using a photoresist 44 patterned in a desired form to form a polycrystalline silicon gate electrode 10 (Fig. 13(C)) on the gate oxide film 14.

After the photoresist 44 is removed, arsenic impurities are ion-implanted (as shown by arrows in Fig. 13(C)) through the gate oxide film 14 with the gate electrode 10 used as a mask to form a drain region 12 and a source region 11 in the single crystal silicon thin film 2. As a result, a transistor channel forming region 45 in which arsenic impurities are not implanted is formed between the drain region 12 and the source region 11 under the gate electrode 10.

The gate oxide film 14 (Fig. 13(D)), over the drain region 12 is partially removed to form a contact hole and the signal line 9 is formed so as to cover the hole. In a similar manner, the gate oxide film 14 over the source region 11 is partially removed to form a contact hole and the source electrode 16 is formed so as to cover the hole. The source electrode 16 is formed of a transparent material such as ITO. The field oxide film 42 and the thermally oxidised silicon film 1 are also transparent. If a substrate of glass, such as Pyrex glass, is used as the supporting substrate 6, the four-layered structure made up of the source electrode 16, the field oxide film 42, the thermally oxidised silicon film 1, and the glass substrate 6 is transparent optically. Thus a transparent substrate on which thin film transistors are formed is obtained, which substrate can be applied to a transparent optical system.

By the manufacturing method illustrated in Figs. 12 and 13, a high quality single crystal silicon thin film is subjected to high temperature film forming, high resolution photolithographic etching, and ion implanting. Thus a field effect type insulating gate transistor can be formed to an order of micron or submicron size. As the single crystal silicon thin film used has very high quality, the insulating gate type transistor thus obtained has good electrical characteristics.

It is convenient to manufacture the SOI substrate in the form of a 0.15m (6 inch) wafer as shown in fig. 7. Such a SOI substrate has a five-layered structure (Fig. 8) which is formed of the single crystal silicon wafer 25, the thermally oxidised silicon film 1 formed on the wafer 25, the single crystal silicon thin film 2 with semiconductor circuit elements, the silicon oxide or nitride film 3, and the element smoothing layer 4 made of silicon oxide, imide series or epoxy type resin. The semiconductor circuit elements are formed on the single crystal silicon film 2 by using a fine processing technique. From the wafer is cut a portion 24 forming an integrated circuit chip 26 (Fig. 9). The integrated circuit chip 26 may be square with a side length of 1.5 cm. The semiconductor circuit elements in the integrated circuit chip 26 include a matrix in a pixel region 29, an X-driver in a side region 27, and a Y-driver in a side region 28. The matrix in the pixel region 29 is formed of fine pixel electrodes and integrated gate field effect transistors corresponding to the fine pixel electrodes, or of PN type photo diodes. The X-driver in the side region 27 is formed of drive circuits for supplying electrical signals to the respective transistors or photo diodes. The Y-driver in the side region 28 is formed of drive circuits acting as scanning circuits for scanning sequentially the respective transistors or for scanning and detecting sequentially the respective photo diodes. As the single crystal thin film has a higher mobility than that of an amorphous thin film or polycrystalline thin film, X-and Y- drivers with high response characteristics can be formed on the same surface together with the matrix in the pixel region.

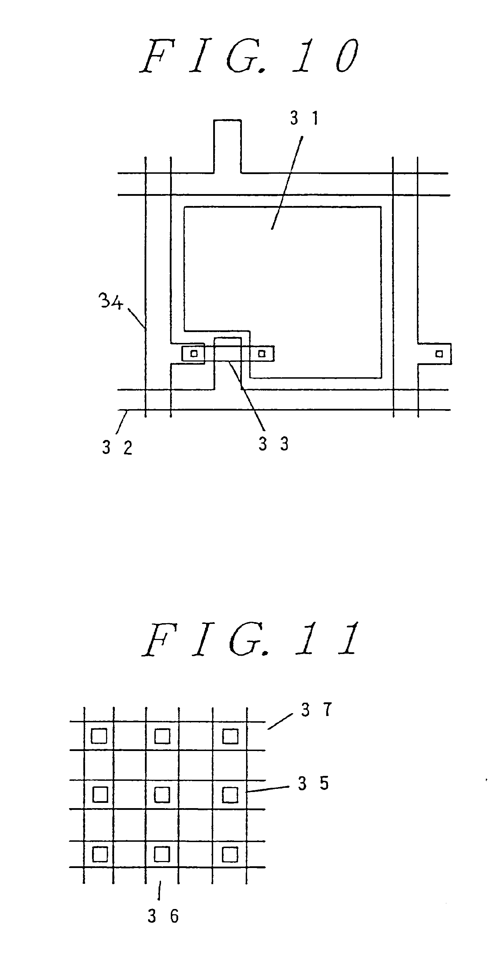

A portion 30 (Fig. 9) of an optical detector array is illustrated diagrammatically and enlarged in Fig. 11. The matrix is formed of parallel, closely spaced X- electrode lines 36 and orthogonal parallel, closely spaced Y- electrode lines 37. A photo detecting element 35 (Fig. 11) is formed at each intersectional point of X- electrode lines 36 and Y- electrode lines 37.

The portion 30 (Fig. 9) of a liquid crystal optical valving device formed in the pixel region 29 on the integrated circuit chip 26 is shown diagrammatically enlarged in Fig. 10. Only a single pixel of the liquid crystal optical valving device is shown. The pixel is formed of a pixel electrode 31, a transistor 33 for exciting in response to a signal on the pixel electrode 31, a signal line 34 for supplying a signal to the transistor 33, and a scanning line 32 for scanning the transistor 33. Each signal line 34 is connected to the X-driver in region 27 and each scanning line 32 is connected to the Y-driver in region 28. The transistor 33 is similar to that shown in Fig. 5 and in the single crystal silicon thin film 2 consists of a drain region, a source region and a gate electrode formed over a channel region between the drain region and the source region. Thus the transistor 33 is of the insulating gate field effect type. The gate electrode is formed as part of the scanning line 32. The pixel electrode 31 is connected to the source region and the drain region is connected to a drain electrode formed as part of the signal line 34.

Such an integrated circuit chip 26 is used in a liquid crystal optical valving device (Fig. 16), The chip 26 has on one face a polariser 51b and on the other face a molecule orientation film 47b. Another substrate 49 has on one face a polariser 51a and on the other face a common electrode 48 which has on its outer face a molecule orientation film 47a. Between the substrate 49 and the chip 26 is disposed a layer 46 of electro-optic material, such as liquid crystal, in contact with the molecule orientation films 47a and 47b. Integrated circuit chip 26 includes drive circuits for exciting drive electrodes in response to a predetermined signal. The integrated circuit chip 26 and the substrate 48 are held at a predetermined gap by spacers 50. The gap generally depends on the optical and orientation characteristics of the liquid crystal material used for the liquid crystal layer 46. For example, the gap is generally about 5 to 10 µm for nematic liquid crystal materials, and is about 1 to 2 µm for ferroelectric liquid crystal materials. Fine particles finished in ball or fibre shape of transparent polymer material such as acrylic resin or silicon dioxide are used as spacers. The spacers 50 may be dispersed uniformly over the entire element. It is desirable to arrange the spacers 50 only in the peripheral portion of the element excluding the pixel region 29 (Fig. 9).

It is particularly desirable not to arrange the spacers 50 on the X-driver side region 27 and the Y-driver side region 28, because the spacers 50 on the pixel electrodes 31 (Fig. 10) may decrease the contrast of the element or may break the single crystal silicon thin film when pressure is applied to control the thickness of the liquid crystal layer 46. When the spacers 50 are arranged over the entire element, an adhesive agent having a Shore curing hardness of over 80 may be used for the resin adhesive layer 5, a silicon oxide film of a thickness of 1 to 2 µm is formed for the element smoothing layer 4, and the thermally oxidised silicon film 1 is controlled to a thickness of over 0.1 µm. Thus in order to control the thickness of the liquid crystal layer 46, pressure can be applied in such a manner that the spacer 50 does not break the single crystal silicon thin film 2.

The integrated circuit chip 26 has a six-layered structure similar to that shown in Fig. 1, which is constructed of the supporting substrate 6 of Pyrex glass, the resin adhesive layer 5, the element smoothing layer 4, the silicon oxide layer 3, the single crystal silicon thin film 2, and the thermally oxidised layer 1. The polariser 51b is adhered on the back surface of the Pyrex supporting substrate 6. The driver circuit is made as an integrated circuit formed on the single crystal silicon thin film 2, and is similar to that shown in Fig. 10. The circuit includes a matrix of field effect type insulating gate transistors 33. In the transistors 33, the source electrodes of the transistors 33 are connected to the corresponding pixel electrodes 31, the gate electrodes are connected to the scanning lines 32, and the drain electrodes are connected to the signal lines 34. The integrated circuit includes X-drivers connected to the row signal lines 34, and Y-drivers connected to the column scanning lines 32.

The substrate 49 (Fig. 16) is of transparent material such as glass, and polariser 51a is adhered to the outer surface thereof. The common electrode 48 is formed on the inner surface of the substrate 49. The molecule orientation films 47a and 47b for orienting liquid crystal molecules in the electrooptic material layer are formed opposite each other, on the inner surfaces of both the integrated circuit chip 26 and the substrate 49 which contact the liquid crystal layer 46.

The liquid crystal layer 46 may be of a nematic liquid crystal material which has the property that the major axis is oriented easily. The orientation films 47a and 47b are of polyimide and their surfaces are prepared by rubbing. If the rubbing direction of the orientation film 47a formed on the substrate 49 is perpendicular to the rubbing direction of the orientation film 47b formed on the integrated circuit chip 26, the liquid crystal molecules between the substrates are twisted by 90°. As a result the polarising angle of light passing the liquid crystal 46 is rotated by 90°. When an electric field is applied between the pixel electrode 31 formed on the integrated circuit chip 26 and the common electrode 48 formed on the substrate 49, the liquid crystal molecules are disposed vertically with respect to the electric field or the substrate, so as to lose their optical activity. The transition is detected optically by the pair of polarisers 51a and 51b. This means that light passing through the liquid crystal layer is passed or blocked in the absence or a presence of voltage. In such a manner, the device according to the present invention has a light valving function for each of the pixels.

With the gate electrode of each transistor 33 (Figure 10) connected to a scanning line 32, the Y-driver supplies a scanning signal sequentially to control ON/OFF operation of the transistors 33. The X-driver applies a display signal to the drain electrode of a selected transistor 33 in the ON state via a corresponding signal line 34. The applied display signal excites the corresponding pixel electrode 31 connected to the source electrode of the transistor 33. Thus an electric field is produced between a selected pixel electrode 31 and the common electrode 48 (Figure 16) and affects the liquid crystal layer 46 so as to substantially maximise its transparency.

When not so selected, the transistor 33 (Figure 10) is in the OFF state and holds a display signal written to the pixel electrode as an electric charge. The liquid crystal layer 46 (Figure 16) has a high specific resistance and acts usually as a capacitive element. An ON/OFF current ratio is used to show the switching characteristic of the drive transistor 33 (Figure 10). The current ratio necessary for a liquid crystal operation can be determined easily by the writing time and the holding time. For example, when the display is a television signal, 90 % of a display signal may be written during about 60 micro seconds for one scanning term. On the other hand, 90% of the electric charges must be held in about 16 milliseconds for one field term. According to the present invention, the transistor 33 is formed on a single crystal silicon thin film 2 with high electric charge mobility, the ON/OFF current ratio of six figures or more can be obtained. Hence an active matrix type liquid crystal light valve with very fast signal response is available. The high mobility characteristic of the single crystal silicon thin film 2 makes it possible to form the peripheral driver circuits in the regions 27 and 28 on the same single crystal silicon thin film.

A liquid crystal light valve according to the present invention may be used in an optical correlation device (Figure 18). The device includes a first liquid crystal light valve 69 and a second liquid crystal light valve 75. Each liquid crystal light valve includes a matrix in a pixel region of approximately 20 x 20 mm, of 480 x 720 pixels, each with a pixel electrode of approximately 18 x 20 µm. The liquid crystal light valve device employs a 5 µm thick nematic liquid crystal layer as liquid crystal material and has a contrast ratio of 50 to 100. An image is driven in response to video signals from a first liquid crystal device drive circuit 65 and a second liquid crystal device drive circuit 72. The image of an object 63 taken by a CCD camera 64 is combined with a reference image from an image memory 66 by means of the first liquid crystal device drive circuit 65 to display the outcome on the first liquid crystal device 69. The image of the object 63 appears as an input image 78 (Fig. 19) and the reference image as a reference image 79. The object 63 is a Chinese character "Hikari" in Mincyotai type and the reference image is a Chinese character "Hikari" in Gothic type. The images are displayed side by side on the first liquid crystal device 60.

The input image 78 and the reference image 79 displayed on the first liquid crystal device 69 are converted to an optical image by coherent light which is obtained by converting light emitted from a first laser 67 (Fig. 18) to parallel rays by a first collimator lens 68. The optical image is subjected to a Fourier transformation on the photoelectric conversion surface of a first CCD 71 using a first Fourier transform lens 70. The first liquid crystal device 69 is arranged at the front focus of the first Fourier transform lens 70 and the photoelectric conversion surface of the first CCD 71 is arranged at the back focus of the first Fourier transform lens 70. The Fourier transform image obtained is called a joint Fourier transform image which resuts from interference between the Fourier transform image of input image 78 and the Fourier transform image of reference image 79.

The joint Fourier transform image produced from the first CCD 71 is displayed on the second liquid crystal device 75 by way of the second liquid crystal device drive circuit 72. The joint Fourier transform image displayed on the second liquid crystal device 75 is read using coherent light which is emitted from a second laser 73 and converted to parallel rays by a second collimator lens 74. Then the coherent light is subjected again to a Fourier transform on the photoelectric conversion surface of a second CCD 77 using a second Fourier transform lens 76. The second liquid crystal device 75 is arranged at the front focus of the second Fourier transform lens 76 and the photoelectric surface of the second CCD 77 is arranged at the back focus of the second Fourier transform lens 76. The Fourier transform image of the joint Fourier transform image taken by the second CCD 77 contains a pair of correlation peaks and other DC bias components, the correlation peaks corresponding to the correlation coefficient between the input image 78 and the reference image 77. The analogy between the input image and the reference image can be judged by measuring the strength of the correlation peak.

In the present embodiment, the optical correlation device is called a joint conversion correlation device (or congruence conversion correlation device). Such an optical correlation device may analyse a real time image and recognise accurately characters with different fonts (Fig. 19).

Most conventional display devices include active matrix type liquid crystal display devices which include transistors formed on an amorphous silicon thin film and are commercially available for liquid crystal television and the similar devices. The conventional liquid crystal display device cannot include pixels of less than 100 µm and cannot operate at a high speed of about 100 Hz because of the manufacturing limitations on the amorphous silicon thin film and limited electric charge mobility. If it is intended to make a display device with a large number of pixels, the display device itself will be large. Therefore there is a disadvantage in that an optical correlation device system is constructed large as a whole.

By the use of the present invention in an optical correlation device, the input image 78 and the reference image 79 displayed on the first liquid crystal device 69 may be sufficiently small and close to each other, in order to produce a sufficiently large interference fringe for detection by the second CCD 77. The interference fringe of a joint Fourier transform image displayed on the second liquid crystal element 75 must be as thin as possible because the long focus distance of the second Fourier transform lens 76 would make the system large.

A liquid crystal device employing the semiconductor thin film element according to the present invention can solve the above problems and can reduce structurally the optical correlation device to about one third in comparison with the use of a conventional liquid crystal display device. In the present embodiment, the first liquid crystal device as well as the second liquid crystal device are operated at video rate. The CCD camera 64, the first CCD 71 and the second CCD 77 can transmit images at a video rate or higher, or substantially at an operational speed of the order of 100 Hz.

Whilst the liquid crystal material has been described as a nematic liquid crystal material, it is possible to construct a display element which provides a high contrast at high speed by controlling the thickness of liquid crystal which is of ferroelectric liquid crystal material to about 2 µm.

The semiconductor thin film element according to the present invention may be used in an optical detector. A transparent type optical detector 56 (Fig. 17) has an input image 54 being a silver chloride photographic plate recording an observed object. Light emitted from a laser 52 is converted to parallel rays by a collimator lens 53 and then illuminates the input image 54 to read it out. The image read out is subjected to a Fourier transform on the light receiving surface of the transparent type optical detector 56 using a Fourier transform lens 55, and a specific high frequency component of the input image 54 read out is filtered using a pinhole 59. The input image subjected to the Fourier transform passed through the transparent type optical detector 56 is subjected again to a Fourier transform using a Fourier transform lens 57 to regain the original input image. The outcome is taken by a CCD camera 58 and is displayed using a CRT 61. The noise in the input image reproduced by the CCD camera 58 can be controlled by proper adjustment of the diameter of the pinhole 59.

It is important to observe what portion of the Fourier transform image of an input image is being filtered when an input image is reconstituted by using a special frequency filter. Usually a proper transparent type optical detector is not available. Hence a beam splitter is arranged at the place where a Fourier transform lens and a transparent type detector are arranged to split the beam and then the split beam is served by another CCD camera. In this case, pinholes must be arranged separately for the two Fourier transform surfaces of the split Fourier transform images. It is difficult to verify whether the respective pinholes are arranged in the same place on the Fourier transform surface. The simple structure of the present embodiment (Fig. 17) can achieve the observation on a CRT 60 connected to the detector 56.

The transparent type optical detector employing a semiconductor thin film element according to the present invention, can measure light strength without shielding light. The resolution equivalent to that of the CCD enables wider applications in the optical measuring field.

There has been described above a semiconductor thin film element according to the present invention, which has a laminated structure with a thermally oxidised silicon film, a single crystal silicon thin film on which a semiconductor circuit element is formed, a silicon oxide or nitride films, an element smoothing layer, a resin adhesive layer, and a supporting substrate formed sequentially. Thus, a single crystal silicon thin film with good electric charge mobility and electrical characteristics can be made. The thin film makes it possible to form a liquid crystal light valve with fine pixels and a large number of pixels, or to form an optical detector with good light transparency. Hence it is possible to display and measure fine images.

In one embodiment of semiconductor thin film element manufacturing method according to the present invention, two single crystal silicon wafers are thermo-press bonded and a single crystal silicon thin film is formed by polishing and etching one of the single crystal silicon wafers. Then a semiconductor thin film element is manufactured by forming integrally semiconductor thin film elements on the single crystal silicon thin film and a second step of bonding and then separating the semiconductor elements formed on the single crystal silicon thin film on a supporting substrate. By the present invention such a semiconductor thin film element can be made easily. The present invention also contributes largely to the technical field on a bonding between a semiconductor and a different kind of material and a three-dimensional semiconductor element structure.

Particularly, the liquid crystal light valve employing the semiconductor thin film element can be a liquid crystal display device with pixels each having a 5 to 20 m square near to a light wavelength. As a conventional coherent light-using display can provide image quality analogous to that of photographic film, the liquid crystal display device contributes largely and technically to a high resolution display device, such as a projector. By constructing an optical correlation device with a CCD, the coherent light-using device makes it possible to miniaturise and provide higher resolution power of the optical correlation device. Furthermore, the pixel with a size near to light wavelength may be applied to a multi-filter type optical correlation device and a three-dimensional display by displaying a CGH (Computer Generated Hologram) hologram using coherent light. In addition, the present invention contributes largely to displaying load matrix such as optical neural network and various optical information processing technology regarding optical digital computing.

In the thus described invention, a semiconductor element is provided in which can be built thin film circuits having electrical characteristics and microstructure equal to or better than a silicon circuit using a single crystal silicon wafer.

The semiconductor thin film element has a structure which is built by forming sequentially a single crystal silicon thin film sandwiched between a thermally oxidised silicon film and a silicon oxide or nitride layer, an element smoothing layer, a fluoro-epoxy series resin adhesive layer, and a supporting substrate.

The single crystal silicon thin film can be formed in a sub-micron fine structure similar to a bulk single crystal silicon. Glass or single crystal silicon substrate can be used as the supporting substrate. Therefore, the semiconductor thin film element can be made as a highly fine, dense, compact semiconductor thin film element or semiconductor optical element. The semiconductor thin film element has a transparent optical detection region or optical modulation region with 100 million pixels or more.

The aforegoing description has been given by way of example only and a person skilled in the art will appreciate that modifications may be made without departing from the scope of the present invention.

## Claims

1. A semiconductor element comprising a laminated structure of:
a single crystal silicon thin film layer (2), at least one semiconductor circuit element being formed to project from a surface of the single crystal silicon thin film layer (2);
a silicon oxide layer (1) formed on the other surface of the single crystal silicon thin film layer (2);
an insulating layer (3) formed on the opposite side of the single crystal silicon thin film layer (2) to the silicon dioxide layer, for protecting the at least one semiconductor circuit element;
an element smoothing layer (4) on the opposite side of the insulating layer (3) to the silicon oxide layer (1);
a resin adhesive layer (5) on the opposite side of the element smoothing layer (4) to the insulating layer (3); and
a supporting substrate (6) on the opposite side of the resin adhesive layer (5) to the element smoothing layer (4),
wherein the surface of the element smoothing layer further from the semiconductor circuit element is smoother than the surface of the element smoothing layer closer to the semiconductor circuit element.

2. An element according to claim 1, wherein the semiconductor circuit element includes an insulating gate field effect type transistor which has a source region (11) formed in the single crystal silicon thin film layer (2), a drain region (12), a channel region (13, 45) formed between the source region (11) and the drain region (12), and a gate electrode (10) formed on the side of the element protective insulating layer (3) over the channel region (13, 45).

3. An element according to claim 1, wherein the semiconductor circuit element includes an optical detecting element comprising a PN junction formed in the single crystal silicon thin film layer.

4. An element according to claim 3, wherein the optical detecting element includes a junction comprising a P-type region (19) formed in the single crystal silicon thin film layer (2), an I-type region (23) interfacing with the P-type region (19), and an N-type region (20) interfacing with the 1-type region (23).

5. An element according to any preceding claim, wherein the supporting substrate is a single crystal silicon substrate (6a), the element including at least one second semiconductor circuit element formed on or in the surface of the single crystal silicon substrate (6a) and a second element smoothing layer (4a) formed between the resin adhesive layer (5) and the second semiconductor circuit element.

6. An element according to claim 5, wherein the second semiconductor circuit element formed in the single crystal silicon substrate (6a) is electrically connected with the semiconductor circuit element formed in the single crystal silicon thin film layer (2) by conductive material provided in a through hole (8) formed in the insulating layer, the smoothing layers and the resin adhesive layer.

7. A liquid crystal light valve comprising: a drive substrate (26) on which a drive electrode and a drive circuit for exciting the drive electrode in accordance with a predetermined signal are formed; an opposed substrate (49) arranged opposite the drive substrate; and a liquid crystal layer (46) arranged between the drive substrate (26) and opposed substrate (49), the drive substrate (26) being formed as a semiconductor element according to any of claims 1 to 6, the drive circuit being formed as a semiconductor circuit element in the single crystal silicon thin film layer thereof, and the drive electrode being arranged integrally on the single crystal silicon thin film layer, whereby an optical change is obtained by the effect on the liquid crystal layer when the drive electrode is excited by the drive circuit.

8. A valve according to claim 7, wherein the drive circuit includes a matrix of drive elements and the drive electrode is formed as a matrix of pixel electrodes excited selectively by the drive elements.

9. A method of manufacturing a semiconductor thin film element substrate comprising adhering two single crystal silicon wafers (25, 38) with one of the wafers having an oxidised film (1) at the adhesion interface, polishing and etching one single crystal silicon wafer (38) to form a single crystal silicon thin film (2), and forming a semiconductor circuit element (10, 11, 12, 14, 45) on the single crystal silicon thin film; forming an insulating layer (3) on the semiconductor circuit element of the single crystal thin film; forming an element smoothing layer (4) on the insulating layer (3); adhering a supporting substrate (6) to the element smoothing layer (4) by a resin adhesive layer (5), and removing the other single crystal silicon wafer (25).

10. An image detecting device comprising a light emitting means (52), a first image displaying means (54) illuminated from the light emitting means (52), an optical detecting means (56) for receiving a converted image obtained by converting an image formed on the first image displaying means (54) by way of a Fourier lens (55) and a second image displaying means (60) for displaying an image signal from the optical detecting means (71), wherein a said image displaying means includes a light valve according to claim 7 or 8.

11. An optical correlation system comprising a first image detecting means (64) for inputting image information, a first drive means (65) for converting a reference image signal and an image signal from the first image detecting means into a display image signal, a first image displaying means (69) for displaying the display image signal from the first drive means, a first light emitting means (67) for illuminating the first image displaying means, a second image detecting means (71) for receiving as a Fourier transform image information based on light from the first image displaying means (69) by way of a first Fourier transfer lens (70), a second drive means (72) for converting image information from the second image detecting means into a display signal, a second image displaying means (75) for displaying an image by input signals from the second drive means, a second light emitting means (73) for illuminating the second image display means (75) and a third image detecting means (77) for receiving information based on light from the second image display means by way of a second Fourier transform lens (76), wherein the first or second image display means comprises a liquid crystal light valve according to claim 7 or 8.

## Patentansprüche

1. Halbleiterelement, umfassend eine laminierte Struktur aus:
einer Einzelkristallsiliziumdünnfilmschicht (2), wobei mindestens ein Halbleiterschaltkreiselement so gebildet ist, dass es von einer Oberfläche der Einzelkristallsiliziumdünnfilmschicht (2) vorragt;
einer Siliziumoxidschicht (1), die an der anderen Oberfläche der Einzelkristallsiliziumdünnfilmschicht (2) gebildet ist;
einer Isolierschicht (3), die an der, der Siliziumdioxidschicht gegenüber liegenden Seite der Einzelkristallsiliziumdünnfilmschicht (2) gebildet ist, um das mindestens eine Halbleiterschaltkreiselement zu schützen;
eine Elementglättungsschicht (4) an der, der Siliziumoxidschicht (1) gegenüber liegenden Seite der Isolierschicht (3);
eine Harzhaftschicht (5) an der, der Isolierschicht (3) gegenüber liegenden Seite der Elementglättungsschicht (4); und
ein Trägersubstrat (6), an der der Elementglättungsschicht (4) gegenüber liegenden Seite der Harzhaftschicht (5),
wobei die Oberfläche der Elementglättungsschicht, die von dem Halbleiterschaltkreiselement weiter weg ist, glatter ist als die Oberfläche der Elementglättungsschicht, die näher zu dem Halbleiterschaltkreiselement liegt.

2. Element nach Anspruch 1, wobei das Halbleiterschaltkreiselement einen isolierenden Gate-Feldeffekttransistor enthält, der eine Source-Region (11), die in der Einzelkristallsiliziumdünnfilmschicht (2) gebildet ist, eine Drain-Region (12), eine Kanalregion (13), die zwischen der Source-Region (11) und der Drain-Region (12) gebildet ist, und eine Gate-Elektrode (10), die an der Seite der Element schützenden Isolierschicht (3) über der Kanalregion (13) gebildet ist, aufweist.

3. Element nach Anspruch 1, wobei das Halbleiterschaltkreiselement ein optisches Detektionselement enthält, das einen PN-Übergang umfasst, der in der Einzelkristallsiliziumdünnfilmschicht gebildet ist.

4. Element nach Anspruch 3, wobei das optische Detektionselement einen Übergang enthält, der eine Region vom P-Typ (19), die in der Einzelkristallsiliziumdünnfilmschicht (2) gebildet ist, eine Region vom I-Typ (23), die an die Region vom P-Typ (19) grenzt, und eine Region vom N-Typ (20), die an die Region vom I-Typ (23) grenzt, umfasst.

5. Element nach einem der vorangehenden Ansprüche, wobei, das Trägersubstrat ein Einzelkristallsiliziumsubstrat (6a) ist, wobei das Element mindestens ein zweites Halbleiterschaltkreiselement enthält, das auf oder in der Oberfläche des Einzelkristallsiliziumsubstrates (6a) gebildet ist, sowie eine zweite Elementglättungsschicht (4a), die zwischen der Harzhaftschicht (4) und dem zweiten Halbleiterschaltkreiselement gebildet ist.

6. Element nach Anspruch 5, wobei das zweite Halbleiterschaltkreiselement, das in dem Einzelkristallsiliziumsubstrat (6a) gebildet ist, durch leitendes Material, das in einem Durchgangsloch (8) bereitgestellt ist, das in der Isolierschicht, den Glättungsschichten und der Harzhaftschicht gebildet ist, elektrisch an das Halbleiterschaltkreiselement angeschlossen ist, das in der Einzelkristallsiliziumdünnfilmschicht (2) gebildet ist.

7. Flüssigkristall-Lichtventil, umfassend: ein Treibersubstrat (26), auf dem eine Treiberelektrode und eine Treiberschaltung zur Erregen der Treiberelektrode in Übereinstimmung mit einem vorbestimmten Signal gebildet sind; ein Gegensubstrat (49), das gegenüber dem Treibersubstrat angeordnet ist; und eine Flüssigkristallschicht (46), die zwischen dem Treibersubstrat (26) und dem Gegensubstrat (29) angeordnet ist, wobei das Treibersubstrat (26) als Halbleiterelement nach einem der Ansprüche 1 bis 6 gebildet ist, die Treiberschaltung als ein Halbleiterschaltkreiselement in dessen Einzelkristallsiliziumdünnfilmschicht gebildet ist, und die Treiberelektrode integral auf der Einzelkristallsiliziumdünnfilmschicht angeordnet ist, wodurch eine optische Änderung durch die Wirkung auf der Flüssigkristallschicht erhalten wird, wenn die Treiberelektrode durch die Treiberschaltung erregt wird.

8. Ventil nach Anspruch 7, wobei die Treiberschaltung eine Matrix von Treiberelementen enthält und die Treiberelektrode als Matrix von Pixelelektroden gebildet ist, die selektiv von den Treiberelementen erregt werden.

9. Verfahren zur Herstellung eines Halbleiterdünnfilmelementsubstrates, umfassend das Aneinanderheften von zwei Einzelkristallsiliziumwafern (25, 38), wobei einer der Wafer einen oxidierten Film (1) an der Haftfläche aufweist, das Polieren und Ätzen eines Einzelkristallsiliziumwafers (38) zur Bildung eines Einzelkristallsiliziumdünnfilms (2), und das Bilden eines Halbleiterschaltkreiselements (10, 11, 12, 14, 45) auf dem Einzelkristallsiliziumdünnfilm; das Bilden einer Isolierschicht (3) auf dem Halbleiterschaltkreiselement des Einzelkristalldünnfilms; das Bilden einer Elementglättungsschicht (4) auf der Isolierschicht (3); das Anheften eines Trägersubstrates (6) an die Elementglättungsschicht (4) durch eine Harzhaftschicht (5), und das Entfernen des anderen Einzelkristallsiliziumwafers (25).

10. Bilddetektionsvorrichtung, umfassend ein Lichtemissionsmittel (52), ein erstes Bildanzeigemittel (54), das von dem Lichtemissionsmittel (52) beleuchtet wird, ein optisches Detektionsmittel (56) zum Empfangen eines konvertierten Bildes, das durch Konvertieren eines Bildes, das auf dem ersten Bildanzeigemittel (54) gebildet wird, mit Hilfe einer Fourier-Linse (55) erhalten wird, und ein zweites Bildanzeigemittel (60) zum Anzeigen eines Bildsignals von dem optischen Detektionsmittel (71), wobei das Bildanzeigemittel ein Lichtventil nach Anspruch 7 oder 8 enthält.

11. Optisches Korrelationssystem, umfassend ein erstes Bilddetektionsmittel (64) zum Eingeben von Bildinformationen, ein erstes Treibermittel (65) zum Konvertieren eines Referenzbildsignals und eines Bildsignals von dem ersten Bilddetektionsmittel in ein Anzeigebildsignal, ein erstes Bildanzeigemittel (69) zum Anzeigen des Anzeigebildsignals von dem ersten Treibermittel, ein erstes Lichtemissionsmittel (67) zum Beleuchten des ersten Bildanzeigemittels, ein zweites Bilddetektionsmittel (71) zum Empfangen von Bildinformationen als Fourier-Transformation auf der Basis von Licht von dem ersten Bildanzeigemittel (69) mit Hilfe einer ersten Fourier-Übertragungslinse (70), ein zweites Treibermittel (72) zum Konvertieren von Bildinformationen von dem zweiten Bilddetektionsmittel in ein Anzeigesignal, ein zweites Bildanzeigemittel (75) für die Anzeige eines Bildes durch Eingangssignale von dem zweiten Treibermittel, ein zweites Lichtemissionsmittel (73) zum Beleuchten des zweiten Bildanzeigemittels (75) und ein drittes Bilddetektionsmittel (77) zum Empfangen von Informationen auf der Basis von Licht von dem zweiten Bildanzeigemittel mit Hilfe einer zweiten Fourier-Transformationslinse (76), wobei das erste oder zweite Bildanzeigemittel ein Flüssigkristalllichtventil nach Anspruch 7 oder 8 umfasst.

## Revendications

1. Elément semi-conducteur comprenant une structure laminée formée par :
une couche mince en silicium monocristallin (2), au moins un élément de circuit à semi-conducteur étant formé de manière à se projeter d'une surface de la couche mince en silicium monocristallin (2) ;
une couche d'oxyde de silicium (1) formée sur l'autre surface de la couche mince en silicium monocristallin (2);
une couche isolante (3) formée sur le côté opposé de la couche mince en silicium monocristallin (2) par rapport à la couche de dioxyde de silicium, afin de protéger ce ou ces éléments de circuit à semi-conducteur;
une couche de lissage d'élément(4) sur le côté opposé de la couche isolante (3) par rapport à la couche d'oxyde de silicium (1) ;
une couche adhésive en résine (5) sur le côté opposé de la couche de lissage d'élément (4) par rapport à la couche isolante (3) ; et
un substrat de support (6) sur le côté opposé de la couche adhésive en résine (5) par rapport à la couche de lissage d'élément (4),
la surface de la couche de lissage d'élément plus éloignée de l'élément de circuit à semi-conducteur étant plus lisse que la surface de la couche de lissage d'élément plus proche de l'élément de circuit à semi-conducteur.

2. Elément selon la revendication 1, l'élément de circuit à semi-conducteur comprenant un transistor de type à effet de champ à grille isolée ayant une zone de source (11) formée dans la couche mince en silicium monocristallin (2), une zone de drain (12), une zone de canal (43, 45) formée entre la zone de source (11) et la zone de drain (12), et une électrode de grille (10) formée sur le côté de la couche isolante de protection d'élément (3) au-dessus de la zone de canal (43, 45).

3. Elément selon la revendication 1, l'élément de circuit à semi-conducteur comprenant un élément de détection optique comprenant une jonction PN formée dans la couche mince en silicium monocristallin.

4. Elément selon la revendication 3, l'élément de détection optique incluant une jonction comprenant une zone de type P (19) formée dans la couche mince en silicium monocristallin (2), une zone de type I (23) formant l'interface avec la zone de type P (19), et une zone de type N (20) formant l'interface avec la zone de type I (23).

5. Elément selon l'une quelconque des revendications précédentes, le substrat de support étant un substrat en silicium monocristallin (6a), l'élément incluant au moins un deuxième élément de circuit à semi-conducteur formé sur ou dans la surface du substrat en silicium monocristallin (6a) et une deuxième couche de lissage d'élément (4a) formée entre la couche adhésive en résine (5) et le deuxième élément de circuit à semi-conducteur.

6. Elément selon la revendication 5, le deuxième élément de circuit à semi-conducteur formé dans le substrat en silicium monocristallin (6a) étant connecté électriquement à l'élément de circuit à semi-conducteur formé dans la couche mince en silicium monocristallin (2) grâce à une matière conductrice fournie dans un trou de passage (8) formé dans la couche isolante, les couches de lissage et la couche adhésive en résine.

7. Variateur de lumière à cristaux liquides comprenant :
un substrat d'excitation (26) sur lequel une électrode d'excitation et un circuit d'excitation pour exciter l'électrode d'excitation en fonction d'un signal prédéterminé sont formés ; un substrat opposé (49) disposé en opposition au substrat d'excitation ; et
une couche de cristaux liquides (46) disposée entre le substrat d'excitation (26) et le substrat opposé (49), le substrat d'excitation (26) étant formé en tant qu'élément semi-conducteur selon l'une quelconque des revendications 1 à 6, le circuit d'excitation étant formé en tant qu'élément de circuit à semi-conducteur dans la couche mince en silicium monocristallin de celui-ci, et l'électrode d'excitation étant intégralement disposée sur la couche mince en silicium monocristallin, moyennant quoi une variation optique est obtenue grâce à l'effet sur la couche de cristaux liquides lorsque l'électrode d'excitation est excitée par le circuit d'excitation.

8. Variateur selon la revendication 7, le circuit d'excitation incluant une matrice d'éléments d'excitation et l'électrode d'excitation étant formée en tant que matrice d'électrodes de pixel excités sélectivement par les éléments d'excitation.

9. Procédé de fabrication d'un substrat d'élément à couche mince semi-conducteur comprenant l'adhésion de deux pastilles en silicium monocristallin (25, 38), l'une des pastilles ayant une pellicule oxydée (1) au niveau de l'interface d'adhésion, le polissage et la gravure d'une pastille en silicium monocristallin (38) afin de former une couche mince en silicium monocristallin (2), et la formation d'un élément de circuit à semi-conducteur (10, 11, 12, 14, 45) sur la couche mince en silicium monocristallin ; la formation d'une couche isolante (3) sur l'élément de circuit semi-conducteur de la couche mince monocristalline; la formation d'une couche de lissage d'élément (4) sur la couche isolante (3); l'adhésion d'un substrat de support (6) sur la couche de lissage d'élément (4) grâce à une couche adhésive en résine (5), et le retrait de l'autre pastille en silicium monocristallin (25).

10. Dispositif de détection d'images comprenant un moyen d'émission de lumière (52), un premier moyen d'affichage d'images (54) illuminé grâce au moyen d'émission de lumière (52), un moyen de détection optique (56) pour recevoir une image convertie obtenue en convertissant une image formée sur le premier moyen d'affichage d'images (54) à l'aide d'une lentille de Fourier (55) et un deuxième moyen d'affichage d'images (60) pour afficher un signal d'image du moyen de détection optique (71), un dit moyen d'affichage d'images incluant un variateur de lumière selon la revendication 7 ou 8.

11. Système de corrélation optique comprenant un premier moyen de détection d'images (64) pour faire entrer de l'information d'image, un premier moyen d'excitation (65) pour convertir un signal d'image de référence et un signal d'image du premier moyen de détection d'images en un signal d'image d'affichage, un premier moyen d'affichage d'images (69) pour afficher le signal d'image d'affichage du premier moyen d'excitation, un premier moyen d'émission de lumière (67) pour illuminer le premier moyen d'affichage d'images, un deuxième moyen de détection d'images (71) pour recevoir, en tant que transformation de Fourier, une information d'image sur la base de la lumière provenant du premier moyen d'affichage d'images (69) à l'aide d'une première lentille de transformation de Fourier (70), un deuxième moyen d'excitation (72) pour convertir de l'information d'image provenant du deuxième moyen de détection d'images en un signal d'affichage, un deuxième moyen d'affichage d'images (75) pour afficher une image grâce à des signaux d'entrée du deuxième moyen d'excitation, un deuxième moyen d'émission de lumière (73) pour illuminer le deuxième moyen d'affichage d'images (75) et un troisième moyen de détection d'images (77) pour recevoir de l'information sur la base de la lumière provenant du deuxième moyen d'affichage d'images à l'aide d'une deuxième lentille de transformation de Fourier (76), le premier ou le deuxième moyen d'affichage d'images comprenant un variateur de lumière à cristaux liquides selon la revendication 7 ou 8.
